Europäisches Patentamt

European Patent Office

Office européen des brevets

(11) Publication number: **0 040 969**
**B1**

# EUROPEAN PATENT SPECIFICATION

(45) Date of publication of patent specification: **16.01.85**

(21) Application number: **81302279.5**

(22) Date of filing: **22.05.81**

(51) Int. Cl.⁴: **B 32 B 5/18, H 03 K 17/00**

(54) Laminated electric element.

(30) Priority: **24.05.80 JP 71822/80 u**

(43) Date of publication of application:
**02.12.81 Bulletin 81/48**

(45) Publication of the grant of the patent:
**16.01.85 Bulletin 85/03**

(84) Designated Contracting States:
**DE FR GB IT**

(56) References cited:
**GB-A-1 223 099**
**GB-A-1 372 237**
**US-A-3 467 569**
**US-A-3 951 250**

(73) Proprietor: **KUREHA KAGAKU KOGYO KABUSHIKI KAISHA**
**9-11 Horidome-cho 1-chome Nihonbashi Chuo-ku**
**Tokyo (JP)**

(72) Inventor: **Endo, Yasushi**
**17 Aza-Watabe Tanabe Watanabe-machi**
**Iwaki-shi Fukushima-ken (JP)**
Inventor: **Suzuki, Seiichi**
**4-8 Shisawa-Sakuta Nakoso-machi**
**Iwaki-shi Fukushima-ken (JP)**

(74) Representative: **Bass, John Henton et al**
**REDDIE & GROSE 16 Theobalds Road**
**London WC1X 8PL (GB)**

Courier Press, Leamington Spa, England.

## Description

The present invention relates to a laminated electric element and, more particularly, to a laminated electric element which contains a plastics film provided on one surface or both surfaces with a conductive layer, and a foam layer laminated on the plastics film through a middle layer.

A variety of electric elements utilizing electric properties of plastics films have been developed and commercialised. The term "electric properties" referred to herein and throughout the specification, unless otherwise stated, may include not only electric properties inherent in plastics films, such as dielectric constant and electric resistance, but other electric properties acquired a posteriori, such as electret properties (performance with respect to charges on the surface of the plastics film) produced therein by treating the plastics film with, for example, a high direct current electric field, and piezoelectric and pyroelectric properties.

Such electric elements are usually used by bringing the plastics films into contact with or taking them away from electrodes for the input and output of electric signals or a common electrode for capacity coupling or a covering for such electrodes. The plastics film may often be employed in the form of a metallized plastics film which comprises a base plastics film and a thin metal film or conductive layer deposited on one surface or on both surfaces thereof as an electrode layer.

One of the purposes of using the metallized film is to utilize the flexibility of the film under stress. In order that a stress may readily be produced in the film by applying a pressure thereto, or to provide the film with a cushioning effect, a material such as a plastics foam, which can act as a cushioning material and has an inwardly and outwardly curved or waved surface, may be employed by depositing an electrode layer or conductive layer thereon.

Where the plastics film in the electric element has a greater thickness than a value which is related to the Young's modulus of the material, the surface of the plastics film can be held flat without being subject to deformation resulting from the curved surface of the foam layer laminated thereon. If the plastics film has a thickness less than such a value, the surface of the flexible or soft plastics film may become curved or waved along with the curved surface of the foam layer, whereby the electrode layer or conductive layer deposited on the plastics film also becomes curved of waved.

The curved or waved plastics film and/or electrode layer may adversely affect performance as a laminated electric element. Where it is employed with an infrared sensor, and infrared image formed on the metal film or conductive layer may tend to become blurred or faded. With an acoustic transducer which is provided with such a waved film and/or layer, sound waves may tend to become warped or deflected. A capacitive switch employing such a curved or waved plastics film and/or electrode layer may not provide the desired electric capacity. In each case, there may be a tendency for the electrode layer to come off because it is attached to the plastics layer with a relatively weak adhesive force.

In accordance with the present invention, there is provided an electric element in which a middle or intermediate layer is disposed or interposed between a plastics film having a conductive layer on at least one surface thereof and a foam layer having a curved or waved surface, whereby flatness of the surfaces of the plastics film and/or the conductive layer can be maintained despite the waved or curved surface of the foam layer.

The invention will be further described with reference to the drawings, in which,

Fig. 1 is a longitudinal cross sectional view of a portion of a known laminated electric element in which a thick metal film is used.

Fig. 2 is a longitudinal cross sectional view of a portion of another known laminated electric element in which a thin metal film is used.

Fig. 3 is a longitudinal cross sectional view of the known laminated electric element of Fig. 1, applied to a capacitive switch.

Fig. 4 is a longitudinal cross sectional view of a portion of an example of the laminated electric element in accordance with the present invention.

Fig. 5 is a longitudinal cross sectional view of the laminated electric element of Fig. 4, applied to a capacitive switch.

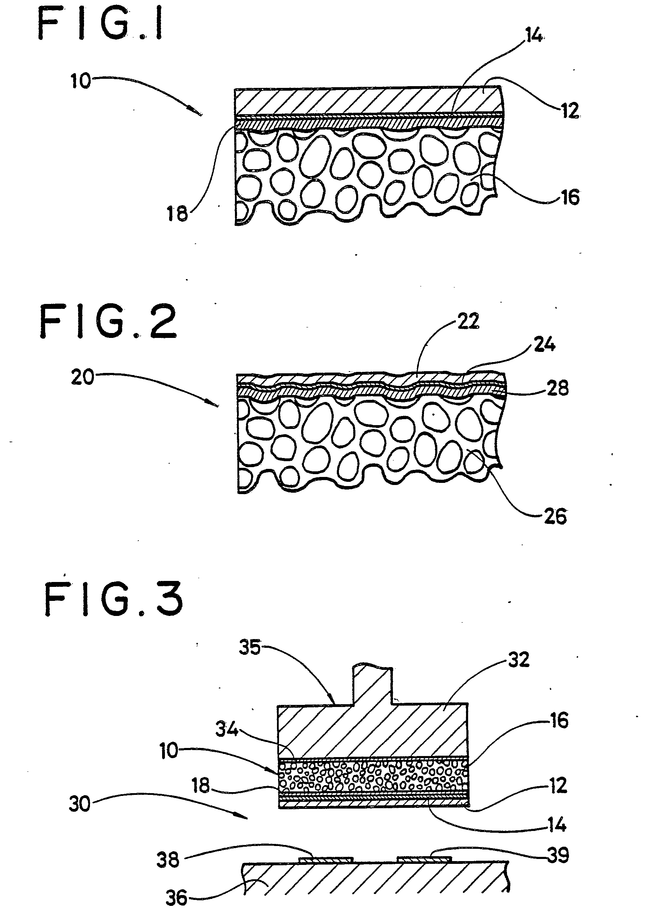

The electric elements in accordance with the present invention will be described in more detail with comparison to known laminated electric elements as shown in Figs. 1 and 2.

A known laminated electric element 10, as shown in Fig. 1, comprises a relatively thick plastics film 12 provided or deposited on one side with an electrode layer 14. The metallized or conductive layer-carrying plastics film 12, is laminated on a foam layer 16 by an adhesive layer 18.

The term "metallized plastics film" referred to throughout the specification is intended to mean a plastics film provided on at least one surface with a metal film or layer or conductive layer as an electrode layer.

In the known laminated electric element 10 as shown in Fig. 1, the plastics film 12 which has a greater thickness than a value which is related to the Young's modulus of the film is laminated on the foam layer 16 having an inwardly and outwardly curved or waved surface so that the conductive layer-carrying or metallized plastics film can remain flat on the surface of the foam layer.

Fig. 2 illustrates another known laminated electric element 20 which is similar in structure to the element 10 as shown in Fig. 1 with the exception that, in place of the thick plastics film 12 a plastics film 22 is employed which is thinner than that of the plastics film 12 and than a certain thickness which is related to the Young's modulus.

Accordingly, where such thin conductive layer-carrying or metallized plastics film is laminated on the curved or waved surface of the foam layer 26, the surface of the plastics film is also rendered curved or waved. As set forth above, such deformation of the plastics film may result in a similar deformation of the electrode layer 24 deposited on the plastics film.

It is found that such deformation of the plastics film 22 and/or the electrode layer 24 may lead to various drawbacks or disadvantages in use as a laminated electric element, as will be described in more detail.

Where such known electric element is applied to an infrared sensor in which a plastics film having both piezoelectric and pyroelectric properties is employed, a piezoelectric action caused by external vibrations may effectively prevent generation of noise because the foam layer 26 can act as a cushioning material. However, where the thickness of the plastics film 22 having pyroelectric properties is rendered as thin as illustrated in Fig. 2 to improve its pyroelectric performance, the surface of the plastics film becomes so curved or waved that an infrared image focused thereon by a condensing lens or a concave mirror (not shown) provided in front of the plastics film 22 becomes faded or blurred and consequently the sensitivity of the electric element is decreased to a great extent.

Where the known electric element 20 containing the plastics film 22 having piezoelectric properties is applied to an acoustic transducer, the generation of noise may be prevented in the same way as in the infrared sensor application set forth above. However, where the thin plastics film as shown in Fig. 2 is employed to improve the piezoelectric property of the film with respect to sounds, the film surface becomes so waved that the thin film may tend to convert sounds electroacoustically in a distorted manner.

In accordance with the known structure as shown in Fig. 2, the plastics film 22 is bonded to the waved or curved surface of the foam layer 26 by an adhesive layer 28 in such a way that adhesion of the plastics film to the foam layer may not be uniform.

Accordingly when the plastics film vibrates, stresses may tend to concentrate locally, so that the electrode layer 24 formed by deposition or other procedures on the film with a relatively weak force may tend to come off.

Where the known laminated electric element 20, as shown in Fig. 2, is applied to an infrared sensor or an acoustic transducer, an additional electrode layer is often provided on the surface of the plastics film 22. In the case of the infrared sensor, the additional electrode layer may be an electrode, for example of indium oxide, which is transparent to infrared rays.

Fig. 3 illustrates an example where the known electric element 10 of Fig. 1 is applied to a capacitive switch 30. A switch key 35 constituting the capacitive switch is composed of a key stem 32 on which the known electric element 10 is fixed by an adhesive layer 34. The switch key is mounted on a machine frame (not shown) which provides an upward and downward movement, when observed on Fig. 3, or a reciprocating movement. Underneath the switch key, there is a plate 36 having stationary input and output electrodes 38 and 39 opposite the plastics film 12.

In Fig. 3, when the switch key 35 is pressed down toward the plate 36 so as to bring the electric element 10 into contact with the plate, a capacitive coupling is provided between the input electrode 38 and the output electrode 39 through the electrode layer 14 in the electric element 10 and consequently a circuit is closed between the stationary electrodes. In this case, the thinner the plastics films 12, the greater the electric capacity at the time of contact, and the higher the dielectric constant of the film, the greater the electric capacity. Accordingly, the known electric element 10 which contains a thick plastics film is not preferred for use in a capacitive switch. In this respect, the known electric element 20 as shown in Fig. 2, which contains a thin plastics film, is more suitable. However, the known laminated electric element 20 having a thin plastics film as shown in Fig. 2 may not produce the desired electric capacity for a capacitive switch at the time of contact because the surface of the film 22 is so waved or curved that an air layer is formed between the wavy surface of the plastics film and the stationary electrodes.

In accordance with the known laminated structures as shown in Figs. 1 to 3, a repetition of switching operations by means of the switch key 35 produces repeated stresses in the plastics film, whereby the electrode layer formed by deposition or other procedures may tend to come off, as in the case of the aforesaid acoustic transducer.

The laminated electric elements in accordance with the present invention can efficiently overcome the drawbacks and disadvantages of the known laminated electric elements as shown in Figs. 1 to 3.

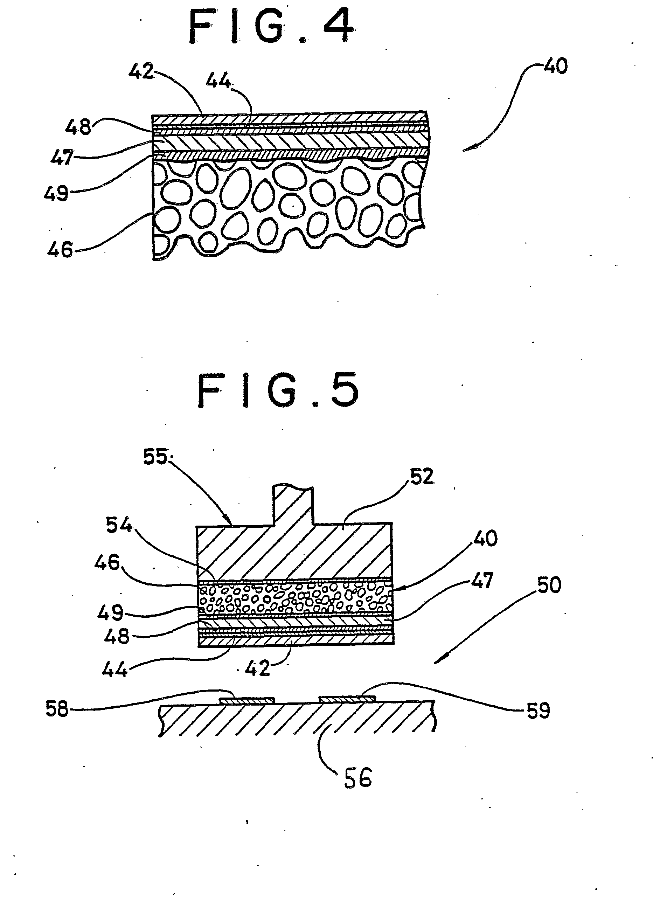

In Fig. 4 the laminated electric element 40 in accordance with the present invention comprises a middle layer 47 interposed between a metallized or conductive layer-carrying plastics film and a foam layer 46. The plastics film 42 is provided with or has deposited on at least one surface a conductive layer or metal film, i.e., the electrode layer 44. The middle layer may be bonded to the metallized plastics film and the foam layer by adhesive layers 48 and 49, respectively, as shown in Fig. 4.

The middle layer 47 is preferably formed as a film or sheet having a flat surface and composed of a relatively soft or flexible synthetic resin, such as polyolefins, e.g., polyethylene or polypropylene; polystyrene; polymethyl methacrylate; polyacrylonitrile; polyamides; polyesters; polycarbonates; low plasticized polyvinyl chloride; low plasticized vinylidene chloride-vinyl chloride copolymers; polyvinyl fluoride; polyvinylidene chloride; polyethylene trifluoride; mixtures thereof or any other suitable resins having a Young's modulus equivalent to or higher than those of the aforesaid resins. The middle layer 47 may be formed as a single layer or a multilayer which in turn may be composed of a single material or mixture thereof, selected from the aforesaid materials.

Although the thickness of the middle layer 47 is not particularly restricted, it is preferred to use a middle layer having a thickness ranging from about 10 $\mu$m to about 100 $\mu$m. Where the middle layer is too thick, the cushioning effect can be afforded to the plastics film by the foam layer 46 may be impaired. Where a middle layer is used which is composed of a material having too low a Young's modulus, or where it is too thin, the interposition of the middle layer between the metallized plastics film and the foam layer does not provide the desired effect. It is further preferred that a middle layer is used which has a greater thickness than the plastics film 42, whereby the surface of the film is maintained or rendered flat when laminated on a foam layer having an inwardly and outwardly curved or waved surface.

The provision of the middle layer 47 may be effected by various methods which are known. The middle layer may be bonded to the metallized or conductive layer-carrying plastics film with an adhesive layer 48 by first coating the adhesive on the surface of the metallized plastics film or on the surface of the middle layer and then superposing the middle layer on the film, and the middle layer thus bonded is further bonded to the foam layer 46 in substantially the same manner. The lamination may also be effected by first coating an adhesive on one or both surfaces of the middle layer and then superposing the metallized plastics film and/or the foam layer. A double-adhesive tape or sheet may be employed which can act as the middle layer 47, having the adhesive layers 48 and 49 on both the surfaces thereof. It may also be possible to use a single-adhesive tape or sheet which can function as the middle layer, having either of the adhesive layers 48 and 49 on one surface thereof. In this case, the single adhesive tape or sheet is first bonded to either the metallized plastics film or the foam layer, and then bonded to the other by an adhesive layer. The double-adhesive or single-adhesive tape or sheet may be a polyester film having a thickness of about 20 $\mu$m with an adhesive layer or layers having each a thickness of about 15 $\mu$m, although it is preferred in practice to use a tape or sheet having a thickness of more than 100 $\mu$m. Although the double-adhesive tape or sheet may sometimes fail to bond in an airtight manner to the metallized plastics film, in which case the adhesive layer involved may tend to become so porous that the metal electrode layer 44 may be corroded, it is convenient to use the double-adhesive tape or sheet because the steps of coating the adhesive layers 48 and 49 can be saved.

The plastics film 42 may be of a dielectric material or, if needed, of a dielectric material having a combination of pyroelectric, piezoelectric or any other electric properties. Such material may include, for example flexible or soft synthetic resins, such as thermoplastic polyester; polyolefins, e.g. polyethylene or polypropylene; polyamides; polycarbonates; polyvinyl halides, e.g., polyvinyl chloride or polyvinyl fluoride; polyvinylidene fluoride; polyolefin halides, e.g. polyethylene trifluoride or polyethylene tetrafluoride; mixtures thereof or other plastics. The plastics film may be composed of a single layer or a multi-layer which in turn is formed by a single material or a mixture of materials as set forth above.

The plastics film may vary in thickness, depending upon its Young's modulus. Where a film having a low Young's modulus and a thickness less than about 20 $\mu$m is employed, it may be hard to render the surface of the film flat when laminated directly on the curved surface of the foam layer. A film having a high Young's modulus and a thickness less than about 10 $\mu$m may also be difficult to keep flat on the curved surface of the foam layer. Further, where a film having a thickness of more than about 25 $\mu$m is used in either case, the metallized plastics film undergoes little or no influence from the curved or waved surface of the foam layer even if no middle layer is provided, as in Fig. 1. It is generally convenient to use a plastics film having a thickness in the range from 2 $\mu$m to 25 $\mu$m depending on the Young's modulus of the material to be used for the plastics film.

The plastics film 42 is provided on at least one surface with a conductive layer or metal film, i.e., the electrode layer 44, composed of a metal, such as nickel, aluminium or gold. The electrode layer may be applied to the surface of the plastics film by deposition or other suitable procedures. Where the electrode layer is required to be penetrated by electromagnetic radiation such as infrared rays, the layer may be composed of a transparent metal oxide, such as indium oxide. The electrode layer may be composed of a material capable of absorbing the radiation, such as gold black or carbon black. The electrode layer may have a thickness generally ranging from about 50 to 200 nm, although the thickness of the layer is not limited thereto.

The foam layer 46 may be composed of an elastic foam, such as plastics foam, e.g., polyurethane foam or natural or synthetic rubber foams. The foam may be of closed-cell material or of open-cell material. Although the thickness of the foam layer is not restricted to a particular value, it is practical to use a foam having a thickness ranging from about 1 to 10 mm.

The adhesive layers 48 and 49 may be composed of conventional adhesives, such as vinyl acetate resins; epoxy resins, acrylic resins; polyurethane resins; mixtures thereof or any other suitable adhesives. They may be of a thickness ranging from about 5 to 60 $\mu$m in each case. Where the adhesive layer 49 is composed of a solution adhesive, the adhesive may be absorbed in the porous foam layer 46 so that the solution adhesive is coated first on the middle layer 47 and then the middle layer is allowed to adhere to the foam layer 46 after volatilization of the solvent of the solution adhesive.

The laminated electric elements in accordance with the present invention having a laminated structure shown in Fig. 4 can utilize the electric properties of the metallized plastic films effectively. It is to be noted that the electric element of the present invention can incorporate a thin metallized plastics film because the provision of the middle layer can prevent the metallized or conductive layer-carrying plastics film from being curved or waved along with or resulting from the curved or waved surface of the foam layer. In the laminated electric elements according to the present invention, the electrode layer is protected by the flat middle layer or film so that the material of the electrode layer is protected against corrosion, even in an atmosphere in which corrosion may tend to occur.

Fig. 5 illustrates a capacitive switch 50 containing the electric element 40 as shown in Fig. 4. In the capacitive switch, a switch key 55 is constituted by fixing the laminated electric element 40 to the bottom surface of a key stem 52 by an adhesive layer 54. The switch key 55 is mounted on a machine frame (not shown) so as to permit an upward and downward movement, when observed on Fig. 5, or a reciprocating movement. This reciprocating movement may include any arbitrary movement, such as a linear reciprocating movement or a circular reciprocating movement. Underrneath the switch key, a plate 56 provided with input and output stationary electrodes 58 and 59 is fixed on the machine frame so that the stationary electrodes face the plastics film 42 of the laminated electric element attached to the switch key 55.

The bottom surface of the switch stem 52 on which the electric element is mounted, may be in any form, such as square or rectangular. Accordingly, the laminated electric element 40 to be attached thereto may be in any form corresponding to the form of the switch stem. The switch stem may be formed of any hard material, such as hard synthetic resins, e.g., polyamide resins (nylon) or polyacetals. The adhesive layer 54 may be composed of any adhesive such as described with respect to the adhesive layers 48 and 49.

Not only may the stationary electrodes 58 and 59 be square or rectangular but they may have a toothed form in which the teeth portions of the two toothed electrodes are arranged so as to be engageable with or to be disposed between each other. The stationary electrodes may be composed of any conductive material, such as those employed for the electrode layer 44 and may be formed by deposition or other suitable procedures for forming print wiring. The electrodes may be covered with a plastics or any other dielectric material as used for the plastics film 42. In this case, the electrode layer 44 may be formed on the outer surface of the plastics film 42.

As shown in Fig. 5, the switch key 55 is moved downwardly to bring the plastics film 42 into contact with a pair of the stationary electrode plates 58 and 59, whereby the film permits a capacitive coupling with the electrodes and thus a circuit between the pair of the electrodes is closed.

Mention will be further made of particular preferred embodiments of the laminated electric elements in accordance with the present invention, when applied to a capacitive switch as shown in Fig. 5, with comparison to the known laminated electric element as shown in Fig. 2 when applied to a capacitive switch.

The laminated electric elements 40 in accordance with the present invention, as shown in Fig. 4 and 5, are composed of a polyester film 42 having a thickness of about 2 $\mu$m, on one side of which is formed an aluminium electrode layer 44 having a thickness of 100 nm, by deposition procedures. On the surface of the electrode layer is bonded a polypropylene film 47 having a thickness of 20 $\mu$m, with a vinyl acetate resin type adhesive layer 48 in a thickness of about 10 $\mu$m. This middle layer 47 is then bonded to a polyurethane foam layer 46 having a thickness of 4 mm by an adhesive layer 49, having an average thickness of about 15 $\mu$m, to provide a laminated electric element as shown in Fig. 4. This electric element is then bonded to a switch stem 52 by an adhesive layer 54 and assembled, with a plate with a pair of the input and output stationary electrodes 58 and 59 having each an area of 43 mm$^2$ whereby a capacitive switch 50 as shown in Fig. 5 is formed. The respective OFF and ON switch capacities of the capacitive switch as formed above were 2 pF and 200 pF.

As a comparison, the laminated electric element 20, as shown in Figs. 2 and 3, was prepared in substantially the same manner with the exception that the adhesive layer 28 had an average thickness of about 15 $\mu$m and no middle layer was provided. A capacitive switch as shown in Fig. 3 was likewise formed with the electric element 20. Its respective OFF and ON switch capacities were 2 pF and 30 pF.

It is found from the comparative results that the capacitive switch containing the laminated electric element in accordance with the present invention has a remarkably ·improved OFF capacity as compared with the known capacitive switch as shown in Fig. 3. It is further found that; when the respective switch keys 55 and 35 as prepared above are observed from the bottom surface, the film 42 of the laminated electric element in accordance with the present invention provides an extremely flat surface, without any deviation, in a mirror image formed thereon, whereas the plastics film on the known capacitive key provides a surface having a number of small upward and downward wave-like curvatures with a mirror image deviated from the correct image and warped or deflected to a remarkable extent.

The laminated electric elements in accordance with the present invention can be applied to a capacitive switch, a piezoelectric instrument, such as an acoustic transducer, a pyroelectric instrument, such as an infrared sensor, and any other suitable device or instrument.

## Claims

1. A laminated electric element (40) comprising a plastics film (42) provided on at least one side thereof with a conductive or electrode layer (44) and a foam layer (46) laminated on the plastics film (42), characterised by an intermediate layer or multilayer (47) interposed between the plastics film (42) and the foam layer (46) whereby a flat surface is provided on the plastics film (42).

2. An element (40) according to claim 1, characterised in that the intermediate layer (47) is bonded to the plastics film (42) and/or the foam layer (46) by an adhesive layer (48 and/or 49).

3. An element (40) according to claim 1 or 2, characterised in that the intermediate layer (47) is composed of a polyolefin, such as polyethylene or polypropylene, polystyrene, polymethyl methacrylate, polyacrylonitrile, a polyamide, a polyester, a polycarbonate, a low plasticized polyvinyl chloride, a low plasticized vinylidene chloride vinyl chloride copolymer, polyvinyl fluoride, polyvinylidene chloride, polyethylene trifluoride or a mixture thereof.

4. An element (40) according to any of claims 1 to 3, characterised in that the intermediate layer (47) has a thickness ranging from 10 to 100 $\mu$m.

5. An element (40) according to any preceding claim, characterised in that the plastics film (42) is provided with a conductive layer (44) between the plastics film (42) and the foam layer (46).

6. An element (40) according to any preceding claim, characterised in that the plastics film (42) is composed of a polyester, a polyolefin, such as polyethylene or polypropylene, a polyamide, a polycarbonate, a polyvinyl halide, such as polyvinyl chloride or polyvinyl fluoride, polyvinylidene fluoride, a polyolefin halide, such as polyethylene trifluoride or polyethylene tetrafluoride, or a mixture thereof.

7. An element (40) according to any preceding claim, characterised in that the plastics film (42) has piezoelectric and/or pyroelectric properties in addition to its dielectric property.

8. A laminated electric element (40) according to any preceding claim, wherein the plastics film (42) has a thickness in the range from 2 $\mu$m to 25 $\mu$m.

9. An element (40) according to any preceding claim, characterised in that the electrode layer (44) is composed of aluminium, gold, nickel, indium oxide or gold black.

10. An element (40) according to claim 9, characterised in that the electrode layer (44) has a thickness ranging from 50 to 200 nm.

11. An element (40) according to claim 2, characterised in that in the or each adhesive layer (48 and/or 49) is composed of a vinyl acetate resin type adhesive, an epoxy resin type adhesive, an acrylic resin type adhesive or a urethane type resin.

12. An element (40) according to claim 11, characterised in that the or each adhesive layer (48 and/or 49) has a thickness ranging from 5 to 60 $\mu$m.

13. An element (40) according to claim 2, characterised in that the intermediate layer (47) comprises a tape or sheet carrying an adhesive layer (48 and/or 49) on one or both surfaces thereof.

14. An element (40) according to any preceding claim, characterised in that the foam layer (46) is composed of a plastics foam, for example of polyurethane, or a natural or synthetic rubber foam.

15. An element (40) according to claim 14, characterised in that the foam layer (46) has a thickness ranging from 1 to 10 mm.

16. An element (40) according to any preceding claim, characterised in that it is mounted on a reciprocatable member (52) preferably by being bonded thereto by an adhesive (54), so that the surface of the plastics film (42) faces a pair of stationary input and output electrodes (58 and 59).

17. An element (40) according to claim 16, characterised in that the stationary electrodes (58 and 59) are coated with a dielectric layer and the electrode layer is provided on the outer surface of the plastics film (42).

## Patentansprüche

1. Geschichtetes elektrisches Bauteil (40) mit einem Kunststoffilm (42), der auf wenigstens einer seiner Seiten mit einer Leit- oder Elektrodenschicht (44) und einer Schaumschicht (46) versehen ist, die auf den Kunststoffilm (42) laminiert sind, gekennzeichnet durch eine Zwischenschicht oder Mehrfachschicht (47), die zwischen den Kunststoffilm (42) und die Schaumschicht (46) zwischengeschaltet ist, wodurch auf dem Kunststoffilm (42) eine ebene Fläche geschaffen wird.

2. Bauteil (40) nach Anspruch 1, dadurch gekennzeichnet, daß die Zwischenschicht (47) mit dem Kunststofffilm (42) und/oder der Schaumschicht (46) durch eine Haftschicht (48 und/oder 49) verbunden ist.

3. Bauteil (40) nach Anspruch 1 oder 2, dadurch gekennzeichnet, daß die Zwischenschicht (47) besteht aus einem Polyolefin wie beispielsweise Polyäthylen oder Polypropylen, Polystyren, Polymethacrylat, Polyacrylonitril, einem Polyamid, einem Polyester, einem Polycarbonat, einem gering plastifizierten Polyvinylchlorid, einem gering plastifizierten Vinylidenchlorid, Vinylchloridcopolymer, Polyvinylfluorid, Polyvinylidenchlorid, Polyäthylentrifluorid oder einer Mischung derselben.

4. Bauteil (40) nach einem der Ansprüche 1 bis 3, dadurch gekennzeichnet, daß die Zwischenschicht (47) eine Dicke im Bereich von 10 bis 100 $\mu$m aufweist.

5. Bauteil (40) nach einem der vorhergehenden Ansprüche, dadurch gekennzeichnet, daß der Kunststofffilm (42) mit einer Leitschicht (44) zwischen dem Kunststofffilm (42) und der Schaumschicht (46) versehen ist.

6. Bauteil (40) nach einem der vorhergehenden Ansprüche, dadurch gekennzeichnet, daß der Kunststofffilm (42) besteht aus einem Polyester, einem Polyolefin, wie beispielsweise Polyäthylen oder Polypropylen, einem Polyamid, einem Polycarbonat, einem Polyvinylhalid, wie beispielsweise Polyvinylchlorid oder Polyvinylfluorid, Polyvinylidenfluorid, einem Polyolefinhalid, wie beispielsweise Polyäthylentrifluorid oder Polyäthylentetrafluorid oder einer Mischung derselben.

7. Bauteil (40) nach einem der vorhergehenden Ansprüche, dadurch gekennzeichnet, daß der Kunststofffilm (42) piezoelektrische und/oder pyroelektrische Eigenschaften zusätzlich zu seiner dielektrischen Eigenschaft aufweist.

8. Bauteil (40) nach einem der vorhergehenden Ansprüche, dadurch gekennzeichnet, daß der Kunststofffilm (42) eine Dicke im Bereich von 2 $\mu$m bis 25 $\mu$m aufweist.

9. Bauteil (40) nach einem der vorhergehenden Ansprüche, dadurch gekennzeichnet, daß die Elektrodenschicht (44) aus Aluminium, Gold, Nickel, Indiumoxid oder gold black besteht.

10. Bauteil (40) nach Anspruch 9, dadurch gekennzeichnet, daß die Elektrodenschicht (44) eine Dicke im Bereich von 50 bis 200 nm aufweist.

11. Bauteil (40) nach Anspruch 2, dadurch gekennzeichnet, daß die oder jede Haftschicht (48 und/oder 49) aus einem Haftmittel aus Vinylacetatharz, einem Haftmittel aus Epoxydharz, einem Haftmittel aus Acrylharz oder einem Urethanharz besteht.

12. Bauteil (40) nach Anspruch 11, dadurch gekennzeichnet, daß die oder jede Haftschicht (48 und/oder 49) eine Dicke im Bereich von 5 bis 60 $\mu$m aufweist.

13. Bauteil (40) nach Anspruch 2, dadurch gekennzeichnet, daß die Zwischenschicht (47) ein Band oder Blatt umfaßt, das eine Haftschicht (48 und/oder 49) auf einer oder beiden Oberflächen trägt.

14. Bauteil (40) nach einem der vorhergehenden Ansprüche, dadurch gekennzeichnet, daß die Schaumschicht (46) aus einem Kunststoffschaum, zum Beispiel Polyurethan, oder aus einem natürlichen oder synthetischen Gummischaum besteht.

15. Bauteil (40) nach Anspruch 14, dadurch gekennzeichnet, daß die Schaumschicht (46) eine Dicke im Bereich von 1 bis 10 mm aufweist.

16. Bauteil (40) nach einem der vorhergehenden Ansprüche, dadurch gekennzeichnet, daß es an einem hin- und hergehenden Glied (52) angebracht ist, vorzugsweise durch Verbinden mit diesem durch ein Haftmittel (54), so daß die Oberfläche des Kunststofffilms (42) zu einem Paar stationärer Eingangs- und Ausgangselektroden (58 und 59) hinweist.

17. Bauteil (40) nach Anspruch 16, dadurch gekennzeichnet, daß die stationären Elektroden (58 und 59) mit einer dielektrischen Schicht überzogen sind und die Elektrodenschicht auf der äußeren Fläche des Kunststofffilms (42) vorgesehen ist.

## Revendications

1. Un élément électrique stratifié (40) comprenant un film de matière plastique (42) muni sur une de ses faces d'une couche conductrice ou couche-électrode (44) et d'une couche de mousse (46) stratifiée sur le film de matière plastique (42), caractérisé par une couche ou multicouche intermédiaire (47) intercalée entre le film de matière plastique (42) et la couche de mousse (46), de sorte que le film de matière plastique (42) est muni d'une surface plane.

2. Un élément (40) selon la revendication 1, caractérisé en ce que la couche intermédiaire (47) est collée au film de matière plastique (42) et/ou à la couche de mousse (46) par une couche de colle (48 et/ou 49).

3. Un élément (40) selon la revendication 1 ou 2, caractérisé en ce que la couche intermédiaire (47) est composée par une polyoléfine telle que polyéthylène ou polypropylène, du polystyrène, du polyméthacrylate de méthyle, du polyacrylonitrile, un polyamide, un polyester, un polycarbonate, un chlorure de polyvinyle faiblement plastifié, un copolymère chlorure de vinylidène-chlorure de vinyle faiblement plastifié, un fluorure de polyvinyle, un chlorure de polyvinylidène, un trifluorure de polyéthylène ou leurs mélanges.

4. Un élément (40) selon l'une quelconque des revendications 1 à 3, caractérisé en ce que la couche intermédiaire (47) a une épaisseur variant de 10 à 100 $\mu$m.

5. Un élément (40) selon l'une quelconque des revendications précédentes, caractérisé en ce que le film de matière plastique (42) est muni d'une couche conductrice (44) entre le film de matière plastique (42) et la couche de mousse (46).

6. Un élément (40) selon l'une quelconque des revendications précédentes, caractérisé en ce que le film de matière plastique (42) est composé d'un polyester, d'un polyoléfine telle que polyéthylène, ou polypropylène; d'un polyamide, d'un polycarbonate, d'un halogénure de polyvinyle, tel que chlorure de polyvinyle ou fluorure de polyvinyle, d'un fluorure de polyvinylidène, d'un halogénure de polyoléfine tel que trifluorure de polyéthylène ou tétrafluorure de polyéthylène, ou leurs mélanges.

7. Un élément (40) selon l'une quelconque des revendications précédentes, caractérisé en ce que le film de matière plastique (42) a des propriétés piézo-électriques et/ou pyroélectriques en plus de ses propriétés diélectriques.

8. Un élément électrique stratifié (40) selon l'une quelconque des revendications précédentes, dans lequel le film de matière plastique (42) a une épaisseur comprise dans l'intervalle de 2 à 25 $\mu$m.

9. Un élément (40) selon l'une quelconque des revendications précédentes, caractérisé en ce que la couche-électrode (44) est composée d'aluminium, d'or, de nickel, d'oxyde d'indium ou de noir d'or.

10. Un élément (40) selon la revendication 9, caractérisé en ce que la couche-électrode (44) a une épaisseur variant de 50 à 200 nm.

11. Un élément (40) selon la revendication 2, caractérisé en ce que la couche ou chaque couche de colle (48 et/ou 49) est composée d'une colle du type résine d'acétate de vinyle, d'une colle du type résine époxydique, d'une colle du type résine acrylique ou d'une colle du type résine d'uréthanne.

12. Un élément (40) selon la revendication 11, caractérisé en ce que la couche ou chaque couche de colle (48 et/ou 49) a une épaisseur de 5 à 60 $\mu$m.

13. Un élément (40) selon la revendication 2, caractérisé en ce que la couche intermédiaire (47) consiste en un ruban ou une feuille portant une couche de colle (48 et/ou 49) sur une ou chacune de ses faces.

14. Un élément (40) selon l'une quelconque des revendications précédentes, caractérisé en ce que la couche de mousse (46) est composée d'une mousse de matière plastique, par exemple de polyuréthanne, ou d'une mousse de caoutchouc naturel ou synthétique.

15. Un élément (40) selon la revendication 14, caractérisé en ce que la couche de mousse (46) a une épaisseur comprise entre 1 et 10 mm.

16. Un élément (40) selon l'une quelconque des revendications précédentes, caractérisé en ce qu'il est monté sur un élément capable d'un mouvement de va-et-vient (52), de préférence par collage par une colle (54), de manière que la surface du film de matière plastique (42) se trouve face à une paire d'électrodes stationnaires d'entrée et de sortie (58 et 59).

17. Un élément (40) selon la revendication 16, caractérisé en ce que les électrodes sta-tionnaires (58 et 59) sont revêtues d'une couche diélectrique et la couche-électrode est disposée sur la surface extérieure du film de ma-tière plastique (42).

# FIG.1

# FIG.2

# FIG.3

1

0·040·969·

# FIG.4

# FIG.5